# EUROPEAN PATENT SPECIFICATION

(11) **EP 4 578 822 B1**
(45) Date of publication and mention of the grant of the patent: **18.11.2026**
(21) Application number: 24223160.3
(22) Date of filing: 24.12.2024
(51) Int. Cl.: B81B 3/00, H04R 19/00

(54) **ELECTROMECHANICAL SYSTEM COMPRISING TWO MOVABLE ELEMENTS AND CAPACITIVE MEASUREMENT OR ACTUATION MEANS**
ELEKTROMECHANISCHES SYSTEM MIT ZWEI BEWEGLICHEN ELEMENTEN UND KAPAZITIVEN MESS- ODER BETÄTIGUNGSMITTELN
SYSTÈME ÉLECTROMÉCANIQUE COMPRENANT DEUX ÉLÉMENTS MOBILES ET DES MOYENS DE MESURE OU D'ACTIONNEMENT CAPACITIFS

(30) Priority: 26.12.2023 FR 2315317
(43) Date of publication of application: 02.07.2025
(73) Proprietor: Commissariat à l'Energie Atomique et aux Energies Alternatives, 75015 Paris (FR)
(72) Inventor: JOET, Loïc, 38054 Grenoble Cedex 09 (FR)
(74) Representative: Cabinet Camus Lebkiri

(56) References cited:
- EP-A1- 2 541 222
- EP-A1- 2 921 836
- EP-A1- 3 766 829
- FR-B1- 3 059 659

## Description

### TECHNICAL FIELD OF THE INVENTION

The technical field of the invention is that of electromechanical systems, in particular of the microelectromechanical systems (MEMS) or nanoelectromechanical systems (NEMS) type. The invention relates more particularly to an electromechanical system comprising a movable element, capacitive measurement or actuation means and a device for transmitting movement between the movable element and the capacitive measurement or actuation means. Such a system can be used as an electroacoustic transducer (e.g. microphone, loudspeaker, etc.) or as a differential pressure sensor.

### TECHNICAL BACKGROUND TO THE INVENTION

Microelectromechanical or nanoelectromechanical microphones represent a rapidly expanding market, thanks in particular to the development of nomadic apparatus, such as tablets, smartphones and other connected objects, in which they are gradually replacing electret microphones.

Microphones measure a rapid variation in atmospheric pressure, also known as acoustic pressure. They therefore include at least one part in contact with the outside.

Most MEMS or NEMS microphones manufactured today are capacitive detection microphones. Fig. 1 represents an example of a capacitive detection microphone 1, described in patent FR3114584B1. Further examples are shown in FR3059659B1 or EP3766829A1.

The microphone 1 comprises a frame (not represented) delimiting at least in part a first zone 11 and a second zone 12, an element 13 movable relative to the frame and a device 14 for transmitting movement between the first zone 11 and the second zone 12. The first and second zones 11-12 of the microphone 1 are sealed off from each other.

The movable element 13, also known as the piston, is in contact with the first zone 11 and comprises a membrane 131 and a rigidifying structure 132 for rigidifying the membrane. The role of the membrane 131 of the piston 13 is to collect, over its entire surface, a pressure difference between its two faces, in order to deduce a variation in atmospheric pressure. One face of the membrane 131 is subjected to atmospheric pressure (the variation in which we wish to detect) and the opposite face of the membrane 131 is subjected to a reference pressure.

In addition, the microphone 1 comprises capacitive detection means 15 arranged in the second zone 12. These capacitive detection means 15 make it possible to measure the displacement of the piston 13, and therefore the difference in pressure between its two faces. They preferably comprise a movable electrode 151 and at least one fixed electrode arranged opposite the movable electrode 151. The electrodes form armatures of a capacitor whose capacitance varies as a function of the displacement of the piston 13.

The transmission device 14 is mounted so as to be rotatably movable relative to the frame by means of several pivot hinges 16. The transmission device 14 comprises two first transmission arms 141 extending in the first zone 11, two second transmission arms 142 extending in the second zone 12 and two transmission shafts 143 extending partly in the first zone 11 and partly in the second zone 12. Each transmission shaft 143 connects a first transmission arm 141 to a second transmission arm 142.

Each first transmission arm 141 comprises a first end coupled to the piston 13 and a second, opposite end coupled to the associated transmission shaft 143. Each second transmission arm 142 comprises a first end coupled to the movable electrode 151 of the capacitive detection means 15 and a second, opposite end coupled to the associated transmission shaft 143.

Patent FR3059659B1 describes a capacitive detection microphone similar to that of Fig. 1. The capacitive detection means comprise a movable electrode and two fixed electrodes between which the movable electrode is disposed. The electrodes form armatures of two capacitors whose capacitances vary in opposite directions according to the displacement of the piston. The measurement of piston displacement is therefore a differential measurement.

To achieve this differential measurement, the capacitors are first charged by applying a DC bias voltage between the movable electrode and the fixed electrodes via a high resistance. The movement of the piston results in a variation in the capacitances, and therefore a variation in the voltage between the fixed electrodes (the charge of the capacitors being substantially constant at audible frequencies, typically greater than 100 Hz) which can be read by an instrumentation amplifier.

These capacitive detection microphones can fail due to a phenomenon of collapse of the movable electrode known as "pull-in", which is common to all electromechanical systems comprising capacitive measurement or actuation means. This collapse phenomenon is caused by the electrostatic force, which tends to bring the movable electrode closer to the fixed electrode (or to one of the fixed electrodes) and which depends on the square of the bias voltage. The electrostatic force, which also depends on the displacement of the movable electrode, can be approximated to first order by a constant force plus the force exerted by a spring of negative stiffness for small displacements.

To avoid this collapse phenomenon (up to a certain point), an elastic force is applied in opposition to the electrostatic force. This elastic force can be generated by springs connecting the movable electrode frame 151 to the microphone frame 1. The greater the stiffness of the springs, the greater the voltage value at which the electrostatic force overcomes the elastic force (so-called "pull-in voltage") and the higher the voltage at which the movable electrode 151 can be biased. This is advantageous because the sensitivity of microphone 1 increases with the bias voltage.

A disadvantage of the capacitive detection microphones described above is that energy is lost in the deformation of the piston 13, the transmission device 14 and the frame of the movable electrode 151, which represents a loss of useful signal when detecting dynamic variations in pressure. One solution for reducing these energy losses, and therefore increasing the sensitivity of the microphone, would be to reinforce the rigidifying structure 132 of the piston 13, the transmission device 14 and the frame of the movable electrode 151. However, this solution would considerably increase the mass of these moving parts, reducing the resonance frequency of the microphone.

### SUMMARY OF THE INVENTION

There is therefore a need to provide an electromechanical system with capacitive detection or capacitive actuation which offers better performance, particularly in terms of sensitivity and resonant frequency.

According to the invention, this need tends to be satisfied by providing an electromechanical system comprising:
- a frame;
- a first element movable relative to the frame; and
- capacitive measurement or actuation means comprising:
   - a first electrode movable relative to the frame; and
   - at least one electrode fixed relative to the frame and separated from the first movable electrode by a first dielectric medium;
- a first movement transmission device connecting the first movable element to the first movable electrode, the first transmission device being rotatably movable relative to the frame by means of a plurality of first pivot hinges.

This electromechanical system is remarkable in that it further comprises a second element movable relative to the frame and in that the second movable element is connected to the capacitive measurement or actuation means.

Preferably, the first movement transmission device further connects the second movable element to the first movable electrode.

Preferably, the capacitive measurement or actuation means further comprise:
- a second electrode movable relative to the frame; and
- at least one additional electrode fixed relative to the frame and separated from the second movable electrode by a second dielectric medium;
and the system further comprises a second movement transmission device connecting the first movable element and the second movable element to the second movable electrode, the second transmission device being rotatably movable relative to the frame by means of a plurality of second pivot hinges.

In a preferred embodiment, the first transmission device comprises:
- a first transmission shaft having a first longitudinal axis of rotation;
- at least one first transmission arm comprising a first end coupled to the first movable element and a second end integral with the first transmission shaft; and
- at least one second transmission arm comprising a first end coupled to the second movable element and a second end integral with the first transmission shaft.

Preferably, each of the first and second movable elements comprises a membrane and a membrane rigidifying structure.

In addition to the features just mentioned in the preceding paragraphs, the electromechanical system according to the invention may have one or several additional features from among the following, considered individually or in any technically possible combinations:
- the second movable element is connected to the first movable electrode;
- the capacitive measurement or actuation means further comprise:
   - a second electrode movable relative to the frame; and
   - at least one additional electrode fixed relative to the frame and separated from the second movable electrode by a second dielectric medium;
and the second movable element is connected to the second movable electrode;
- the first transmission device is located on a first side of the membrane of the first (respectively second) movable element and the rigidifying structure of the first (respectively second) movable element comprises a first beam located on the first side of the membrane, the first beam extending in the direction of the length of the first (respectively second) movable element, preferably along a median line of the first (respectively second) movable element;
- the first beam has a length greater than or equal to 50% of the length of the first (or second) movable element;
- the first beam has a thickness of between 5 µm and 800 µm;
- the rigidifying structure of the first (or second) movable element also comprises a second beam located on a second, opposite side of the membrane and superimposed on the first beam;
- the second beam has a thickness strictly less than that of the first beam, preferably between 5 µm and 50 µm;
- the rigidifying structure of the first (respectively second) movable element further comprises edges located on a second, opposite side of the membrane and extending perpendicular to the first beam;
- the first movable element and the second movable element are identical;
- the first movable element and the second movable element are not identical
- the capacitive measurement or actuation means are located between the first movable element and the second movable element;
- at least one of the first pivot hinges is located at the level of the first movable electrode;
- another of the first pivot hinges is located at a first end of the first transmission device; and
- another of the first pivot hinges is located at a second, opposite end of the first transmission device;
- at least one of the second pivot hinges is located at the second movable electrode;
- another of the second pivot hinges is located at a first end of the second transmission device;
- another of the second pivot hinges is located at a second, opposite end of the second transmission device;
- the first movable element and the second movable element are in contact with a first zone and the first movable electrode is located in a second zone sealed off from the first zone;
- the first and second movable elements are in translation relative to the frame;
- the first and second movable elements are in rotation relative to the frame;
- the first movable electrode is connected to the first transmission shaft;
- the first movable electrode is integral with the first transmission shaft, with the result that the first movable electrode is mounted so as to be rotatably movable about the first longitudinal axis of rotation;
- the second transmission device comprises:
   - a second transmission shaft having a second longitudinal axis of rotation;
   - at least one third transmission arm comprising a first end coupled to the first movable element and a second end integral with the second transmission shaft; and
   - at least one fourth transmission arm comprising a first end coupled to the second movable element and a second end integral with the second transmission shaft;
- the second movable electrode is connected to the second transmission shaft;
- the second movable electrode is integral with the second transmission shaft, with the result that the second movable electrode is mounted so as to be rotatably movable about the second longitudinal axis of rotation.

### BRIEF DESCRIPTION OF THE FIGURES

Further features and advantages of the invention will be clear from the description given below, by way of illustration and in no way limitation, with reference to the attached figures, of which:
- Fig. 1 is a partial perspective view of a capacitive detection microphone according to prior art;
- Figure 2 is a partial bottom view of an electromechanical system according to a first embodiment, this electromechanical system comprising capacitive detection or actuation means;
- Figure 3 is a partial top view of the capacitive detection or actuation means of the electromechanical system in Figure 2;
- Figure 4A is a cross-sectional view of the electromechanical system along sectional plane A-A in Figure 3;
- Figure 4B is a cross-sectional view of the electromechanical system along sectional plane C-C of Figure 3;
- Figure 5 is a partial bottom view of an electromechanical system according to a second embodiment;
- Figure 6 is a partial top view of the electromechanical system in Figure 5;
- Figure 7 is a partial bottom view of an electromechanical system according to a third embodiment.

For the sake of clarity, identical or similar elements are marked by identical reference signs throughout the figures.

### DETAILED DESCRIPTION

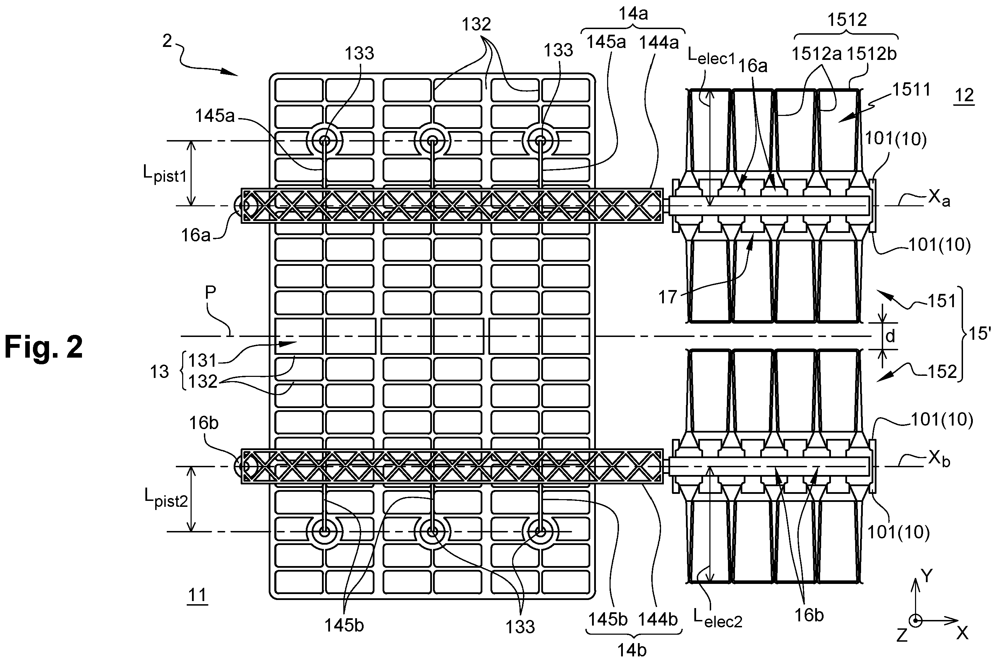

Figures 2, 3 and 4A to 4B represent a part of an electromechanical system 2 with capacitive detection or capacitive actuation according to a first embodiment. This electromechanical system 2 may form an electroacoustic transducer, for example a microphone or a loudspeaker, or a differential pressure sensor. In the following description, the example of a microphone with capacitive detection will be taken.

The electromechanical system 2 comprises:
- a frame 10;
- a movable element 13 in contact with a first zone 11;
- capacitive detection (or measurement) means 15' comprising a first electrode 151 movable relative to the frame 10, a second electrode 152 movable relative to the frame 10, the first and second movable electrodes 151-152 being located in a second zone 12 sealed from the first zone 11; and
- a first device 14a for transmitting movement between the movable element 13 and the first movable electrode 151 (i.e. between the first zone 11 and the second zone 12); and
- a second device 14b for transmitting movement between the movable element 13 and the second movable electrode 152.

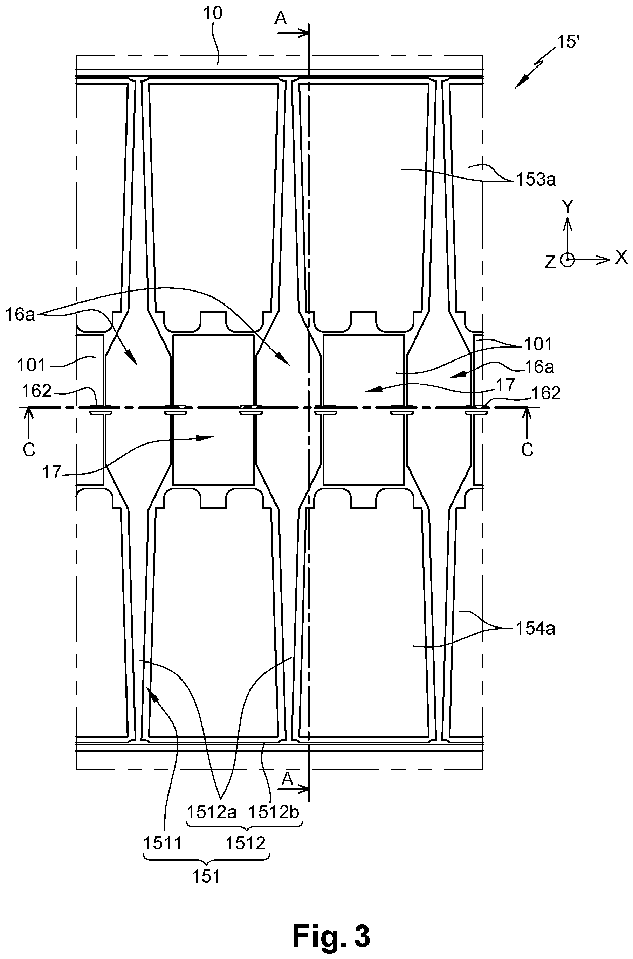

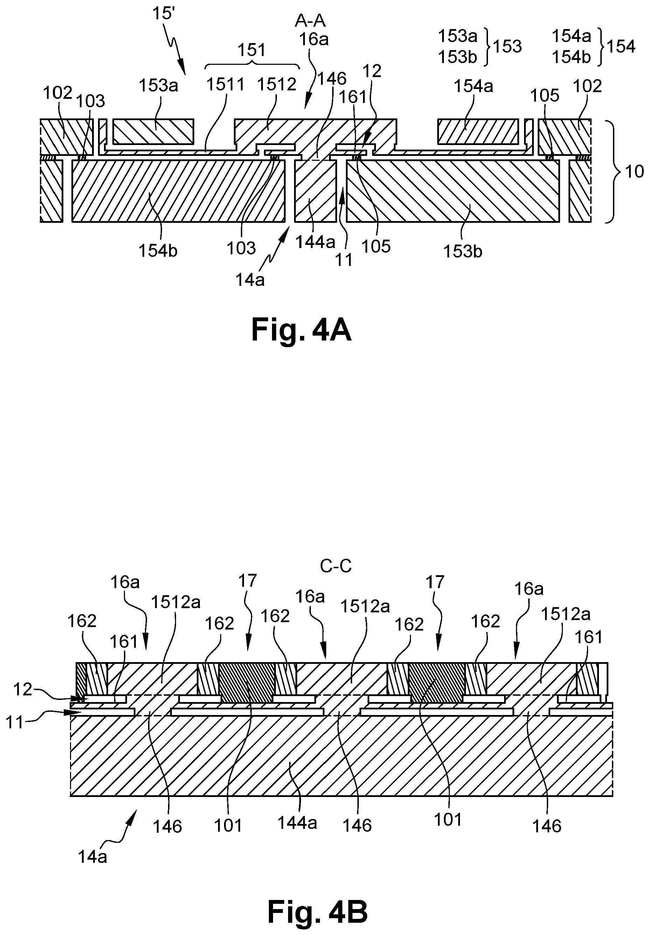

Figure 2 is a bottom view of the electromechanical system 2 showing first portions 101 of the frame 10, the movable element 13, the transmission devices 14a-14b and the movable electrodes 151-152 of the capacitive detection means 15'. Figure 3 is a top view showing only a part of the capacitive detection means 15' (including the first movable electrode 151). Figures 4A to 4B are different cross-sectional views of the electromechanical system 2, respectively according to the cross-sectional planes A-Aand C-C represented in Figure 3. They represent in part of the frame 10, the first transmission device 14a and the capacitive detection means 15'.

The movable element 13, hereinafter referred to as the piston, is movable in translation relative to the frame 10, in a direction (Z) perpendicular to the plane (XY) of Figure 2. It preferably comprises a membrane 131 and a rigidifying structure 132 for rigidifying the membrane 131, also referred to as a skeleton or armature. The role of the membrane 131 of the piston 13 is to collect, over its entire surface, a pressure difference between its two faces, in order to deduce a variation in atmospheric pressure.

The membrane 131 of the piston 13 can partly delimit a closed reference volume, where a reference pressure prevails. It separates this reference volume from a cavity open to the outside environment. One face of the membrane 131 is therefore subjected to the reference pressure and an opposite face of the membrane 131 is subjected to atmospheric pressure (the variation of which is to be detected in the case of a microphone). Alternatively, the reference volume can be quasi-closed, in the sense that there is a trench around the piston (which is cut away). This trench allows the piston to move and allows air to leak between the reference volume and the outside. This leakage is small so that pressures can equalise slowly, filtering out only low-frequency pressure variations.

The first zone 11 encompasses the cavity open to the outside environment, subjected to atmospheric pressure, and the reference volume subjected to the reference pressure.

The capacitive detection means 15' measure the displacement of the piston 13, and therefore the pressure difference between its two faces. In addition to the first and second movable electrodes 151-152, they comprise at least one fixed electrode (relative to the frame 10), separated from the first movable electrode 151 by a first dielectric medium, and at least one additional fixed electrode, separated from the second movable electrode 152 by a second dielectric medium.

Each movable electrode and associated fixed electrode(s) form the armatures of one or several capacitors whose capacitance varies as a function of the displacement of the piston 13. The fixed electrodes may also be called "counter-electrodes".

The first dielectric medium and the second dielectric medium are not solid (but are preferably constituted by a gas or a mixture of gases), so as not to hinder the movement of the movable electrodes 151. The second dielectric medium is identical to the first dielectric medium, as the movable electrodes 151-152 are both located in the second zone 12.

Advantageously, the second zone 12 is a controlled atmosphere chamber to reduce the phenomena of viscous friction and the associated acoustic noise. By "controlled atmosphere chamber" we mean a chamber under reduced pressure, typically less than 1000 mbar, and preferably less than 1 mbar. In this way, the second zone 12 is subjected to a pressure well below atmospheric pressure or the reference pressure.

The first transmission device 14a is mounted so as to be rotatably movable relative to the frame 10, by means of several first pivot hinges 16a. It comprises a first transmission shaft 144a and one or several first transmission arms 145a, also known as lever arms.

The first transmission shaft 144a has a first longitudinal axis of rotation Xa (hereinafter referred to as the first axis Xa), which extends in a first direction X. In other words, the first transmission shaft 144a can pivot on itself, about the first axis Xa. It extends opposite the piston 13, opposite a zone located between the piston 13 and the first movable electrode 151 and opposite the first movable electrode 151.

Advantageously, the first movable electrode 151 is integral with the first transmission shaft 144a, which means that there is no relative movement between the first movable electrode 151 and the first transmission shaft 144a. The first movable electrode 151 is therefore also mounted so as to be rotatably movable about the first axis Xa.

The electromechanical system 2 is thus devoid of movement transformation devices between the first transmission device 14a and the first movable electrode 151, such as torsion blades for switching from rotation to translation. As a result, no energy is lost in these transformation members (for example, by deformation of the torsion blades).

The first transmission arms 145a, for example three in number in Figure 2, can extend perpendicularly to the first axis Xa, in other words in a second direction Y perpendicular to the first direction X. The first and second directions X-Y, together with a third perpendicular direction Z, constitute an orthogonal reference frame.

Each first transmission arm 145a comprises a first end coupled to the piston 13 and a second end integral with the first transmission shaft 144a. One or several coupling elements 133 connect the rigidifying structure 132 for the piston 13 to the first end of each first transmission arm 145a. A part at least of the coupling elements 133 (for example torsion blades) allow the transition from a translational movement (piston 13) to a rotational movement (first transmission shaft 144a and first movable electrode 151) while strongly coupling their displacement along the third direction Z. These coupling elements 133 are capable of elastic deformation.

The translational movement of the piston 13 causes the first transmission arms 145a, and therefore the first transmission shaft 144a, to rotate about the first axis Xa. This rotational movement is then transmitted to the first movable electrode 151.

The first pivot hinges 16a, for example six in number, are aligned, here in the first direction X. Preferably, one of the first pivot hinges 16a is located at the end of the first transmission shaft 144a, on the piston 13 side (i.e. opposite the first movable electrode 151), while other first pivot hinges 16a are located on the first movable electrode 151 side. As will be described in detail below, the first movable electrode 151 is preferably connected to the first transmission shaft 144a at these other first pivot hinges 16a.

The second transmission device 14b is also mounted so as to be rotatably movable relative to the frame 10, by means of second pivot hinges 16b. It is constructed in the same way as the first transmission device 14a. More particularly, it comprises a second transmission shaft 144b having a second longitudinal axis of rotation Xb (hereinafter referred to as the second axis Xb) and second transmission arms 145b (three, for example). Each second transmission arm 145b comprises a first end coupled (via one or several coupling elements 133) to the piston 13 and a second end integral with the second transmission shaft 144b. The second transmission arms 145b preferably extend perpendicularly to the second axis Xb.

The second movable electrode 152 is advantageously integral with the second transmission shaft 144b and therefore rotates about the second axis Xb.

The second pivot hinges 16b are preferably distributed along the second axis Xb in the same way as the first pivot hinges 16a are distributed along the first axis Xa (one of them is located at the end of the second transmission shaft 144b and others are located at the second movable electrode 152).

The first transmission arms 145a are coupled to a first half of the piston 13 (the upper half in Figure 2) and the second transmission arms 145b are coupled to a second half of the piston 13 (the lower half in Figure 2). In this way, the transmission devices 14a-14b support the piston 13 and hold it in translation. Preferably, the piston 13 is held solely by the first and second transmission arms 145a-145b. In this way, a greater proportion of the energy collected by the piston 13 is transmitted to the movable electrodes 151-152.

As illustrated in Figure 2, the first axis Xa and the second axis Xb are advantageously parallel. This helps to reduce the overall dimensions of the electromechanical system 2 and provides uniform support for the piston.

The first movable electrode 151 and the second movable electrode 152 can be identical and arranged symmetrically with respect to a plane P separating the first and second halves of the piston 13. This symmetry makes it possible to obtain an identical reaction on the two halves of the piston so that the latter is held securely in translation.

The first transmission device 14a and the second transmission device 14b can also be symmetrical with respect to the plane P. The first transmission shaft 144a and the first movable electrode 151 then pivot in one direction (about the first axis Xa), while the second transmission shaft 144b and the second movable electrode 152 pivot in the opposite direction (about the second axis Xb).

The piston 13 may also be symmetrical with respect to the plane P.

The symmetries of the piston 13 and the transmission devices 14a-14b enable the energy collected by the piston 13 to be distributed equally between the first movable electrode 151 and the second movable electrode 152. Indeed, the mass of the piston 13 is distributed equally between the first and second halves, and therefore between the first and second transmission devices 14a-14b.

Rotating the first movable electrode 151 and the second movable electrode 152, along the same axis of rotation as the first transmission device 14a and the second transmission device 14b respectively, makes it possible to obtain a greater displacement of the movable electrodes 151-152 for a given displacement of the piston 13, without however increasing the overall dimensions of the electromechanical system 2. The movable electrodes 151-152 can therefore be as close as possible to the piston 13.

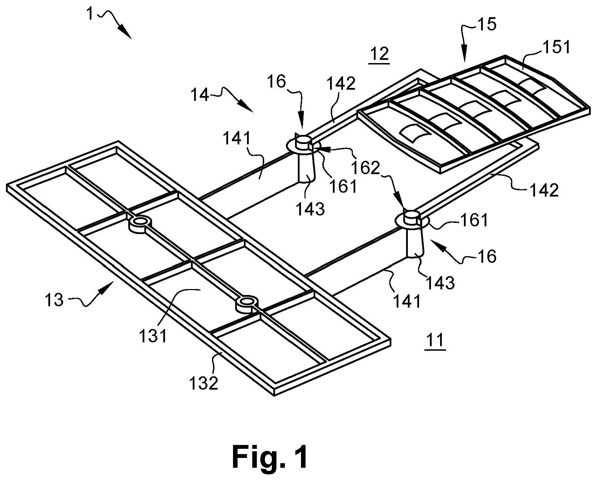

The change from one movable electrode (Fig.1) to two movable electrodes (Fig.2) does not significantly increase the overall dimensions of the electromechanical system 2 either, as the two movable electrodes 151-152 can be arranged opposite each other in the extension of the piston 13..

The displacement of each movable electrode 151, 152 relative to that of the piston 13 is a function of the distance Lₚᵢₛₜ₁, Lₚᵢₛₜ₂ between the first end of the transmission shafts 145a, 145b and the corresponding axis of rotation Xa, Xb. This distance may be of the same order of magnitude as the distance L_{elec1}, L_{elec2} between a longitudinal edge (i.e. along X) of the rotating electrode 151, 152 and the axis of rotation Xa, Xb.

More precisely, the displacement in Z of the longitudinal edge of the first movable electrode 151 is given by the following relationship:
[Math. 1] ${d}_{Zelec 1} = \frac{{L}_{elec 1}}{{L}_{pist 1}} \times {d}_{Zpist}$
where *d_{Zpist}* is the displacement in Z of the piston 13 (and therefore of all the first ends of the first and second transmission arms 145a-145b), *L*_{*elec*1} is the distance between the longitudinal edge of the first movable electrode 151 and the first axis Xa and Lₚᵢₛₜ₁ is the distance between the first end of each first transmission arm 145a and the first axis Xa.

The Z displacement of the longitudinal edge of the second movable electrode 152 is given by the following relationship:
[Math. 2] ${d}_{Zelec 2} = \frac{{L}_{elec 2}}{{L}_{pist 2}} \times {d}_{Zpist}$
where *L*_{*elec*2} is the distance between the longitudinal edge of the second movable electrode 152 and the second axis Xb and Lₚᵢₛₜ₂ is the distance between the first end of each second transmission arm 14b and the second axis Xb.

The transmission shafts 144a-144b and the transmission arms 145a-145b can be particularly rigid, and therefore not very sensitive to deformations which are equivalent to energy losses. This rigidity of the transmission shafts 144a-144b and the transmission arms 145a-145b can in particular be conferred by a large thickness (measured in the third direction Z), preferably between 5 µm and 800 µm, and more preferably between 50 µm and 200 µm. The transmission shafts 144a-144b and the transmission arms 145a-145b are advantageously formed by etching a substrate. This substrate can be thinned to a thickness less than 200 µm.

As the transmission shafts 144a-144b rotate on themselves, their inertia remains low and does not have a negative impact on the resonance frequency of the electromechanical system 2. However, they can be apertured, as illustrated in Figure 2, in order to optimise their stiffness to inertia ratio. The transmission shafts 144a-144b are preferably perforated at least in the portion facing the piston 13. This also makes it possible to limit damping with the piston 13 (known as "squeeze film damping"), which is a source of noise.

The width of the transmission shafts 144a-144b (measured in the first direction Y) is of the same order of magnitude as their thickness, in order to minimise their inertia. Advantageously, it is between 5 µm and 800 µm.

The capacitive detection means 15' will now be described in more detail, with reference only to the first movable electrode 151 (connected to the first transmission device 14a). Nevertheless, this description applies *mutatis mutandis* to the second movable electrode 152 (connected to the second transmission device 14b), since it may be identical to the first electrode 151. Similarly, the description that will be given of the first pivot hinges 16a applies to the second pivot hinges 16b.

With reference to Figures 2 and 3, the first electrode 151 may comprise a membrane 1511 and a rigidifying structure 1512 of the membrane 1511. The rigidifying structure 1512 preferably comprises a plurality of first beams 1512a extending parallel to one another. It may further comprise second beams 1512b connecting the first beams 1512a at their ends.

The first beams 1512a preferably extend in the second direction Y, advantageously from a first edge to an opposite second edge of the first movable electrode 151. They are advantageously evenly spaced from one another, to rigidify the membrane 1511 uniformly. The second beams 1512b preferably extend in the first direction X (i.e. perpendicularly to the first beams 1512a).

The first movable electrode 151 advantageously has one or several planes of symmetry, for example a plane parallel to the XZ plane (therefore perpendicular to the first beams 1512a) and another plane parallel to the YZ plane.

The rigidify structure 1512 of the first movable electrode 151 is advantageously anchored, or fused, to the first transmission device 14a at a part of the first pivot hinges 16a. Compared with the microphone 1 of Fig. 1, the electrostatic system 2 therefore lacks the second transmission arms 142 extending into the second zone 12.

More particularly, the rigidify structure 1512 of the first movable electrode 151 is connected to the first transmission device 14a, and more particularly to the first transmission shaft 144a, by pillars 146 visible in Figures 4A and 4C. The pillars 146 of the first transmission device 14a are similar to the transmission shafts 143 of Fig. 1, in that they extend partly into the first zone 11 and partly into the second zone 12. Indeed, the seal between the first zone 11 and the second zone 12 is also made at the level of the first pivot hinges 16a associated with the first movable electrode 151.

The first transmission device 14a is thus reduced to first elements extending exclusively in the first zone 11 (the first transmission shaft 144a and the first transmission arms 145a) and to second elements (the pillars 146) which extend partly in the first zone 11 and partly in the second zone 12. This reduction of the first transmission device 14a makes it possible to limit energy losses. In particular, there are no more losses due to deformation of the second transmission arms 142.

The electromechanical system 2 is particularly compact, as several functions, namely the rotation of the first transmission device 14a, the seal between the two zones 11-12 and the connection to the first movable electrode 151, are carried out in the same place.

Anchoring between the rigidifying structure 1512 and the first transmission device 14a is preferably achieved by means of the first beams 1512a. A part at least of these are fused to the first transmission device 14a, each at a corresponding first pivot hinge 16a. The anchoring point of each first beam 1512a is advantageously located halfway along its length. Thus, the axis of rotation of the first movable electrode 151 lies in one of the planes of symmetry of the first movable electrode 151 (that perpendicular to the first beams 1512a). The length of the first beams 1512a is measured in the second direction Y, while their width is measured in the first direction X.

Each first beam 1512a merged with the first transmission device 14a advantageously has a width which decreases away from the corresponding first pivot hinge 16a. In other words, the width of the first beams 1512a is maximum at the level of the first pivot hinges 16a.

In this first embodiment of the electromechanical system 2, each of the first beams 1512a of the stiffening structure 1512 is fused to the first transmission device 14a. In other words, each first beam 1512a is associated with a first pivot hinge 16a. The number of first pivot hinges 16a on the side of the first movable electrode 151 is therefore equal to the number of first beams 1512a. This arrangement makes it possible to create a space 17 between two successive first pivot hinges 16a.

For each first pivot hinge 16a, the frame 10 may comprise two distinct first portions 101 arranged on either side of the first beam 1512a associated with the first pivot hinge. The first beam 1512a is preferably connected to each of the first portions 101 of the frame 10 by a torsion bar 162 (see Fig. 3).

As represented by Figures 3, 4A and 4B, the capacitive detection means 15' preferably comprise two counter-electrodes 153-154 associated with the first movable electrode 151: a first counter-electrode 153 referred to as positive and a second counter-electrode 154 referred to as negative. Preferably, at least a part of the membrane 1511 of the first movable electrode 151 is located between the two counter-electrodes 153-154 (see Figs.4A-4B). The first movable electrode 151 and the counter-electrodes 153-154 thus form the armatures of two capacitors whose capacitances vary in opposite directions. A differential measurement of the displacement of the piston 13 can thus be obtained. The surfaces of the counter-electrodes 153-154 facing the first movable electrode 151 are advantageously identical, thanks to the symmetry of the first movable electrode 151 and of the counter-electrodes 153-154 with respect to the first pivot hinges 16a (the plane of symmetry coincides with the sectional plane C-C).

Advantageously, each of the counter-electrodes 153, 154 comprises a first portion 153a, 154a and a second portion 153b, 154b located on either side of the membrane 1511 and on either side of the first pivot hinges 16a. The first portion 153a, 154a, known as the upper portion, and the second portion 153b, 154b, known as the lower portion, of the same counter-electrode are electrically connected. This arrangement makes it possible to obtain a fully differential measurement, even if the distance between the membrane 1511 and the upper portions 153a-154a of the counter-electrodes (referred to as the upper air gap) is different from the distance between the membrane 1511 and the lower portions 153a-154a of the counter-electrodes (lower air gap).

The lower portions 153b-154b of the counter-electrodes 153-154 extend under the first beams 1512a of the stiffening structure 1512, on either side of the first pivot hinges 16a. In contrast, the upper portions 153a-154a of the counter-electrodes 153-154 are preferably each divided into several blocks (or sub-portions) separated by the first beams 1512a, as illustrated in Figure 3. As the upper portions 153a-154a of the counter-electrodes 153-154 are inscribed in the stiffening structure 1512, their surface zone facing the membrane 1511 is smaller than that of the lower portions 153b-154b.

With reference to Figure 4A, the lower portions 153b-154b of the counter-electrodes 153-154 are preferably secured to an annular portion 102 of the frame 10, located at the periphery of the first movable electrode 151, by means of annular seals 103, 105 made of an electrically insulating material (one annular seal per lower portion 153b, 154b). These annular seals 103, 105, for example made of silicon oxide, further ensure the seal between the first zone 11 and the second zone 12.

Alternatively, the capacitive detection means 15' may comprise (for each movable electrode) only one counter-electrode (lower or upper), two counter-electrodes (upper and lower) but located on only one side of the pivot hinges 16 (pseudo-differential detection) or even two lower or upper counter-electrodes arranged on either side of the pivot hinges 16 (differential detection).

As previously indicated, the seal between the first and second zones 11-12 of the electromechanical system 2 can be made at the first pivot hinges 16a located on the side of the first movable electrode 151. As illustrated in Figures 4A and 4B, each first pivot hinge 16a associated with the first movable electrode 151 comprises a sealed insulating element 161, capable of elastically deforming under the effect of the rotational displacement of the first transmission device 14a. The sealed insulating element 161 is preferably in the form of a sealing membrane.

Each sealed insulating element 161 is preferably traversed by an associated pillar 146 of the first transmission device 14a. The sealed insulating element 161 extends, for example, from the associated pillar 146 to the lower portions 153b-154b of the counter-electrodes 153-154 (see Fig. 4A) and to the first portions 101 of the frame 10 (see Fig. 4B), to which it is anchored by means of the annular seals 103, 105 made of electrically insulating material.

In addition, each first pivot hinge 16a (associated with the first movable electrode 151) advantageously comprises two torsion blades 162 (one per first portion 101 of the frame 10). The torsion blades 162 are dimensioned so as to be able to deform in torsion and allow the first transmission device 14a and the first movable electrode 151 to rotate, while limiting their translational movements, in particular in the third Z direction (so-called "out-of-plane" translation). The two torsion blades 162 connect the rigidifying structure 1512 of the first movable electrode 151 (fused to the pillar 146 of the first transmission device 14a) to the first portions 101 of the frame 10 (see also Fig. 4C). They are preferably aligned and arranged diametrically opposite the first beam 1512a associated with the first pivot hinge 16a.

The first pivot hinge 16a located at the end of the first transmission shaft 144a advantageously comprises a sealed insulating element 161 (preferably in the form of a membrane) and two torsion blades 162, but does not participate in the sealing between the first and second zones 11-12 (being located only in the first zone 11).

The electromechanical system 2 comprises elastic means connected to the first movable electrode 151 and configured to generate an elastic force which opposes the movement of the first movable electrode 151. The role of these elastic means is to combat the pull-in phenomenon of the first movable electrode 151. Their stiffness influences the collapse voltage (or "pull-in voltage" of the system), and therefore the ability to bias the first movable electrode 151.

The elastic "anti-pull-in" means connect (mechanically) the rigidifying structure 1512 of the first movable electrode 151 to the frame 10 and/or to elements integral with the frame, such as the counter-electrodes 153-154, possibly via the pillars 146 of the first transmission device 14a. Thus, the stiffness of the first transmission device 14a or the stiffness of the rigidifying structure 1512 itself are not considered to be "anti-pull-in" elastic means.

The "anti-pull-in" elastic means here comprise the sealed insulating elements 161 and, where appropriate, the torsion blades 162. The sealed insulating elements 161 and the torsion blades 162 thus perform several functions simultaneously.

The anti-pull-in elastic means are connected to the rigidifying structure 1512 where it is most rigid, i.e. at the first pivot hinges 16a. In this way, the stiffness of the anti-pull-in spring means is not degraded by series elements of too low stiffness. This stiffness can also be easily controlled by adjusting the dimensions of the sealed insulating elements 161 and the torsion blades 162. The sealed insulating elements 161 can be defined by anisotropic etching of a sacrificial layer (SiO₂, for example) and are produced in a structural layer of controlled thickness. This type of etching gives good control over the dimensions of the sealed insulating elements 161. As a result, the stiffness of the sealed insulating elements 161 shows little dispersion (mainly between the different electromechanical systems manufactured on the same wafer or on different wafers).

The second movable electrode 152 is advantageously connected to the second transmission device 14b in the same way as the first movable electrode 151 is connected to the first transmission device 14a. Thus, the electromechanical system 2 also comprises "anti-pull-in" elastic means connected to the second movable electrode 152, these elastic means preferably comprising the sealed insulating elements 161 and, where appropriate, the torsion blades 162 of the second pivot hinges 16b.

The sealed insulating elements 161 and, where applicable, the torsion blades 162, advantageously constitute the only "anti-pull-in" means of the electromechanical system 2. The electromechanical system 2 is therefore particularly compact.

The electromechanical system 2 described above can be manufactured using the methods described in patents FR3059659B1 and FR3114584B1, in particular starting from a stack of layers comprising successively a substrate, a first sacrificial layer and a first structural layer. The stack may in particular be a multilayer structure of the silicon-on-insulator (SOI) type, commonly known as an SOI substrate.

The substrate is used in particular to produce, by etching, the first elements of the transmission devices 14a-14b (transmission shafts 144a-144b and transmission arms 145a-145b), the lower portions of the counter-electrodes 153-154 and a part of the frame 10. The substrate may be made of a semiconductor material, for example silicon.

The first structural layer is used in particular to produce the membrane 131 of the piston 13, the membrane 1511 of the movable electrodes 151-152 and the sealed insulating elements 161 (sealing membranes). Its thickness is less than that of the substrate, preferably between 100 nm and 10 µm. It is preferably constituted from the same material as the substrate, for example silicon.

The first sacrificial layer is intended to disappear in part during manufacture of the electromechanical system 2 to free the membrane 131 of the piston 13, the membrane 1511 of the movable electrodes 151-152 and the sealed insulating elements 161. In particular, its thickness defines the distance between the membrane 1511 and the lower portions of the counter-electrodes 153-154 (lower air gap). This layer also acts as a stop layer during etching of the substrate, the membrane 152a and the second structural layer (the "MEMS" layer described later). The remaining parts of the first sacrificial layer form the annular seals 103, 105 and the lower pillars 104. The first sacrificial layer can be constituted by a dielectric material, preferably a silicon nitride or a silicon oxide, for example silicon dioxide (SiO₂). Its thickness is, for example, between 100 nm and 10 µm.

As described in the aforementioned patents, a second sacrificial layer is deposited on the first structural layer and a second structural layer is formed on the second sacrificial layer, preferably by epitaxy.

The second structural layer is etched to define at least a part of the rigidification structure 132 of the piston 13, the rigidification structure 1512 of the movable electrodes 151-152, the torsion blades 162, the upper portions of the counter-electrodes 153-154, the first portions 101 and the second annular portion 102 of the frame 10. Advantageously, it is made of the same material as the first structural layer, for example silicon. The thickness of the second structural layer is preferably between 5 µm and 50 µm.

The rigidifying structure 1512 of each movable electrode 151, 152 is fused to the corresponding transmission device 14a, 14b, by growing the second structural layer directly from the substrate, at the location of the pivot hinges 16a, 16b (the first and second sacrificial layers having been opened beforehand). The pillars 146 of the transmission devices 14a, 14b are formed during this epitaxial growth.

The second sacrificial layer is used in particular as a stop layer during etching of the second structural layer. It is partly removed to free the membrane 131 of the piston 13, the membrane 1511 of the movable electrodes 151-152 and the sealed insulating elements 161. Its thickness defines the distance between the membrane 1511 and the upper portions of the counter-electrodes 153-154 (upper air gap). The second sacrificial layer is advantageously formed from the same dielectric material as the first sacrificial layer, for example silicon oxide. Its thickness can be between 100 nm and 10 µm.

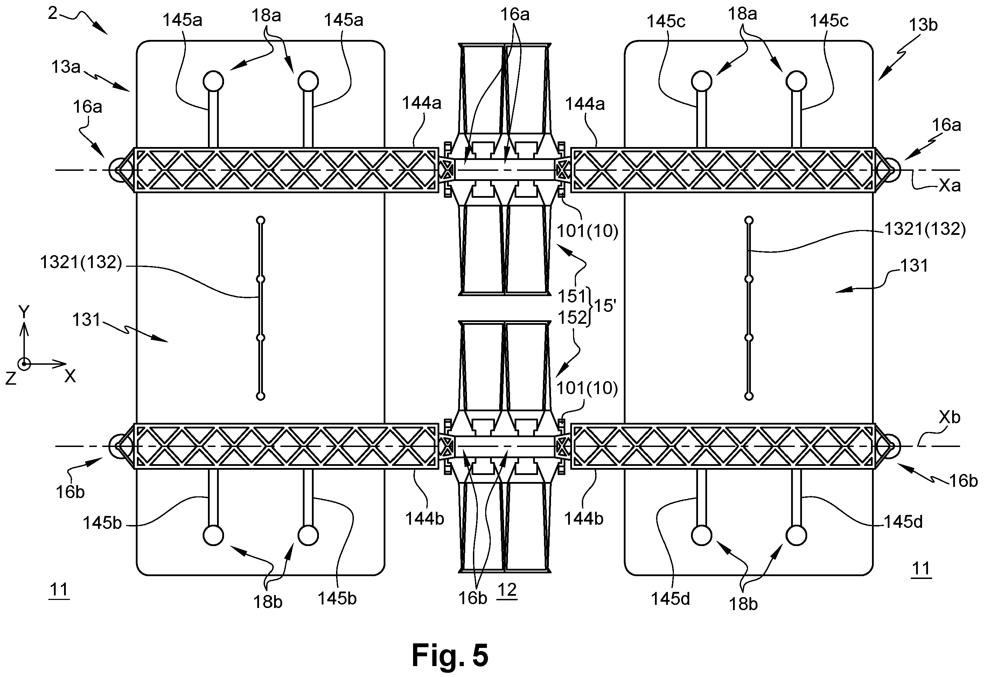

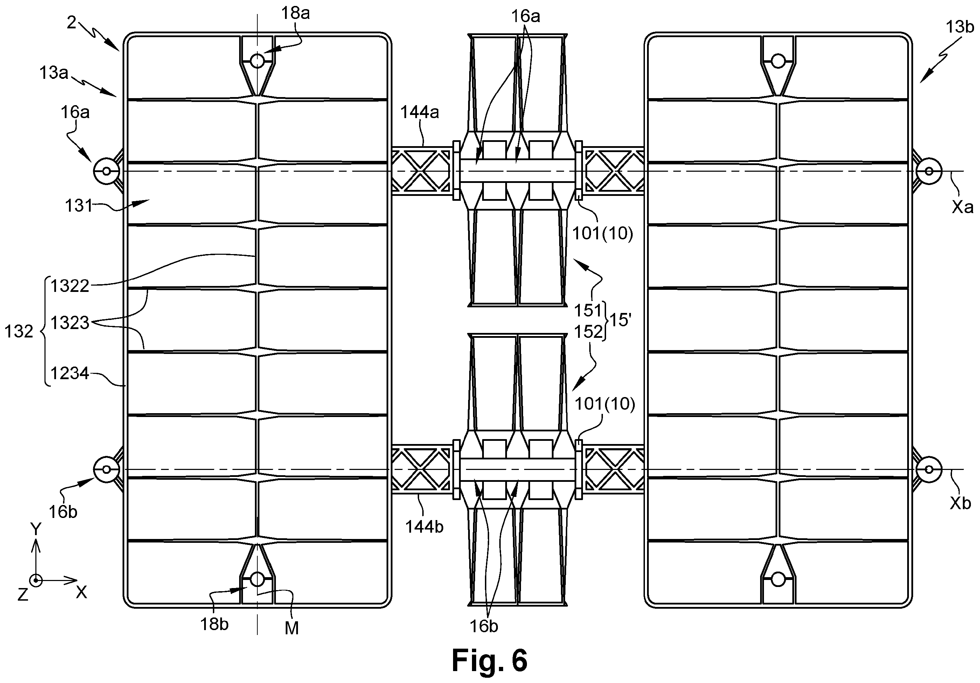

Figures 5 and 6 represent a second embodiment of the electromechanical system 2. Figure 5 is a bottom view of a part of the electromechanical system 2, similar to Figure 2. Figure 6 is a top view of the same part of the electromechanical system 2.

This second embodiment differs from the first embodiment mainly in that the electromechanical system 2 comprises two movable elements or pistons, rather than a single one.

Thus, in addition to the frame 10, the first and second transmission devices 14a-14b and the capacitive detection means 15' comprising the two movable electrodes 151-152, the electromechanical system 2 comprises a first piston 13a and a second piston 13b.

The first piston 13a is connected, on the one hand, to the first movable electrode 151 by the first transmission device 14a, and, on the other hand, to the second movable electrode 152 by the second transmission device 14b.

The second piston 13b is connected, on the one hand, to the first movable electrode 151 by the first transmission device 14a and, on the other hand, to the second movable electrode 152 by the second transmission device 14b.

Thus, each transmission device 14a, 14b connects the two pistons 13a-13b to the capacitive detection means 15', and more particularly to the movable electrode 151, 152 associated with said transmission device 14a, 14b.

The way in which the movable electrodes 151-152 are constructed and the way in which they are connected to the transmission devices 14a-14b have been described previously in relation to Figures 2, 3 and 4A-4B. The movable electrodes 151-152 in Figure 5 are simply smaller than those in Figure 2, in order to best represent the two pistons.

The capacitive detection means 15' can be located between the two pistons 13a-13b. Each of the pistons 13a-13b separates a cavity open to the outside from a reference volume. Thus, in this configuration, the first zone 11 comprises two cavities open to the outside and two reference volumes (which can communicate with each other). The second zone 12, which contains the movable electrodes 151-152, is located between the pistons 13a-13b.

The pistons 13a-13b are subjected to the same pressure difference. They are also mounted so that they can move relative to the frame 10 in the same way, preferably in translation along the third direction Z. The pistons 13a-13b therefore have the same displacement.

The pistons 13a-13b each comprise a membrane 131 and a membrane rigidifying structure 132. The first piston 13a has an effective surface zone and mass equal to or approximately equal (within 5%) to those of the second piston 13b. The effective surface zone of a piston is defined as the surface zone in contact with the first zone 11 (in other words the surface zone that harvests the pressure difference). The electromechanical system 2 is therefore balanced overall.

Viewed from the front, the pistons 13a-13b preferably have the same shape, for example rectangular with rounded corners. The dimensions (length, width) of the first piston 13a are equal or substantially equal (to within 5%) to those of the second piston 13b. The width of a piston is measured in the first direction X and its length is measured in the second direction Y.

For example, the two pistons 13a-13b in Figure 5 have the same length (measured in Y) as the single piston 13 in Figure 2, but a width (measured in X) less than or equal to half that of piston 13.

For an equivalent piston surface zone, the electromechanical system 2 comprising two pistons offers better performance, particularly in terms of sensitivity and resonant frequency, because it offers a better compromise between rigidity and mass than the electromechanical system comprising a single piston (Figure 2).

Indeed, as the two pistons 13a-13b are smaller than a single piston, they are more rigid, all other things being equal (thickness, rigidifying structure, etc.), and are therefore subject to less deformation. They can be more rigid for the same (cumulative) mass or be lighter for the same level of rigidity, or even lighter while being more rigid. In addition, the parts of the transmission devices 14a-14b that hold the pistons 13a-13b (each located between two pivot hinges 16a, 16b positioned on either side of a piston) are shorter (due to the smaller width of the pistons) and can therefore be lightened without reducing their rigidity.

The pistons 13a-13b are advantageously identical. They can be arranged symmetrically with respect to a plane passing through the movable electrodes 151-152. Similarly, the transmission devices 14a, 14b are preferably symmetrical with respect to this plane.

As in the first embodiment (see Fig. 2), the first transmission device 14a is mounted so as to rotate relative to the frame 10 by means of several first pivot hinges 16a. In the embodiment shown in Figure 5, at least one of the first pivot hinges 16a is located at the first movable electrode 151, another first pivot hinge 16a is located at a first end of the first transmission device 14a (beyond the first piston 13a) and yet another first pivot hinge 16a is located at a second opposite end of the first transmission device 14a (beyond the second piston 13b).

The second transmission device 14b is rotatably mounted relative to the frame 10 by means of the second pivot hinges 16b. The second pivot hinges 16b are preferably arranged in the same way as the first pivot hinges 16a.

In this second embodiment, each transmission device 14a, 14b comprises:
- a transmission shaft 144a, 144b, rotating about its longitudinal axis Xa, Xb and to which the movable electrode 151, 152 is connected;
- one or more transmission arms (or lever arms) 145a, 145b having a first end integral with the transmission shaft 144a, 144b and a second end coupled to the first piston 13a;
- one or more additional transmission arms (or lever arms) 145c, 145d having a first end integral with the transmission shaft 144a, 144b and a second end coupled to the second piston 13b.

Advantageously, the transmission devices 14a and 14b have a lattice structure which enables them to transmit movement with as little deformation as possible, while minimising inertia.

The first piston 13a and the way in which it is connected to the transmission devices 14a-14b will now be described in more detail. This description applies mutatis mutandis to the second piston 13b.

Thus, the rigidifying structure 132 for the first piston 13a advantageously comprises, on the side of the membrane 131 where the transmission devices 14a-14b are located, a first beam 1321 which extends along the length of the first piston 13a. The first beam 1321 can extend along the median line M of the first piston 13a, as represented in Figure 5, or parallel to this median line M at a distance of less than a quarter of the width of the first piston 13a. This first beam 1321 advantageously has the same thickness as the transmission shafts 144a, 144b and the transmission arms 145a, 145b, i.e. a thickness of between 5 µm and 800 µm. It is formed at the same time as the transmission shafts and arms, by etching the substrate.

Thanks to its great thickness, the first beam 1321 contributes greatly to rigidifying the first piston 13a in its greatest dimension (length) and therefore to reducing the deformation of the first piston 13a. It therefore provides a significant gain in sensitivity.

The first beam 1321 preferably extends over more than 50% of the length of the first piston 13a.

Preferably, on this side of the membrane 131, the rigidifying structure 132 comprises only the first beam 1321.

On the other side of the membrane 131, represented by Figure 6, the rigidifying structure 132 for the first piston 13a advantageously comprises a second beam 1322 superimposed on the first beam 1321. This second beam 1322 has a thickness strictly less than that of the first beam 1321. It can be formed in the second structural layer described above, the thickness of which is between 5 µm and 50 µm. The second beam 1322 can have a length equal to that of the first beam 1321.

The second beam 1322 thus extends at least part of the first beam 1321 in the third direction Z to reach a greater thickness. It only slightly increases the mass of the first piston 13a (to a lesser extent than the first beam 1321, due to its smaller thickness), but considerably increases the rigidity of the piston (as this varies as a function of the cube thickness).

On the same side as the second beam 1322, the rigidifying structure 132 may also comprise edges 1323 oriented perpendicularly to the first beam 1321 (so preferably parallel to the first axis Xa). These ridges 1323 rigidify the first piston 13a across its width. As the width is the smallest side of the first piston 13a, the ridges 1323 do not need to be thick (unlike the first beam 1321). The edges 1323 preferably have the same thickness as the second beam 1322 (between 5 µm and 50 µm). In this way, they do not significantly increase the mass of the first piston 13a. They are also formed by etching the second structural layer. They can extend from one edge of the first piston 13a to the other.

A part at least of the edges 1323 may come to bear against stop elements belonging to the frame of the electromechanical system 2. These stop elements, for example in the form of a beam extending opposite the edges 1323, are provided to prevent the destruction of the first piston 13a and the movable electrodes 151, 152, when the first piston 13a is subjected to a very large pressure difference (such as during reliability tests).

Finally, the rigidifying structure 132 may comprise a frame 1324 located at the periphery of the first piston 13a. This frame 1324 preferably has the same thickness as the second beam 1322. It may also be formed by etching the second structural layer.

Multiplying the number of pistons considerably simplifies their rigidifying structure. The mass of the two pistons 13a-13b is reduced compared with that of the piston 13 in Figure 2, while their rigidity is increased. This represents a twofold gain in performance.

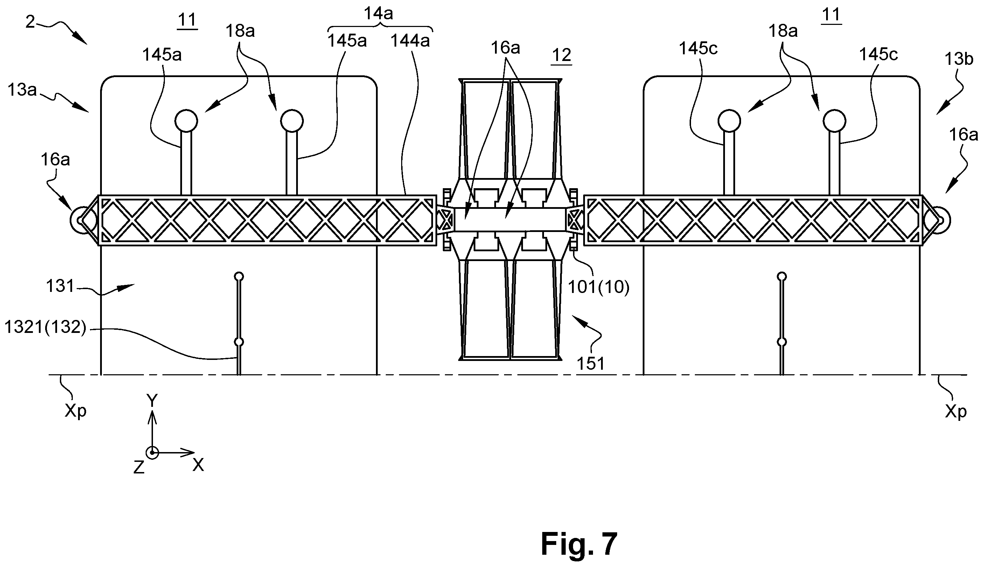

The electromechanical system 2 does not necessarily comprise the two movable electrodes 151-152 and the two transmission devices 14a-14b. It may comprise a single movable electrode and a single transmission device (see Fig.7), or a single movable electrode and two transmission devices connected to this single movable electrode.

Figure 7 represents a third embodiment in which the electromechanical system 2 comprises, in addition to the two pistons 13a-13b, a single movable electrode 151 (for example of the type represented by Figure 5) and a single transmission device 14a (for example of the type represented by Figure 5).

The pistons 13a-13b are here rotatably movable about an axis Xp (and not translatable), by means of pivot hinges or hinges (not represented) distinct from the first pivot hinges 16a. The rotational movement of the pistons 13a-13b (about the axis Xp) rotates the transmission shaft 144a of the transmission device 14a (about its own axis Xa), via the transmission arms 145a, 145c, and the transmission shaft 144a moves the movable electrode 151 (here in rotation about the axis Xa).

The electromechanical system 2 is not limited to the embodiments described in relation to Figures 2 to 7 and many alternatives and modifications of the electromechanical system will become apparent to the person skilled in the art.

In particular, the first piston 13a and the second piston 13b may be connected to the capacitive detection means 15', and in particular to the first movable electrode 151 (or to the first and second movable electrodes 151-152) by two (four) separate transmission devices.

Furthermore, the second piston 13b is not necessarily connected to the same movable electrode (or the same movable electrodes) as the first piston 13a. Thus, the first piston 13a may be connected to the first movable electrode 151 by a first transmission device, while the second piston 13b is connected to the second movable electrode 152 by a second transmission device.

The transmission devices 14a-14b, and more particularly the transmission shafts 144a-144b, can adopt other geometries. The number of transmission arms 145a, 145b may be greater than 3.

The electromechanical system 2 may also comprise, for each transmission device 14a, 14b, one or several additional pivot hinges, not represented by the figures, between that located at each end of the transmission shaft 144a, 144b and those connecting the movable electrode 151, 152. These additional pivot hinges are preferably located in the first zone 11 and therefore do not contribute to the seal between the two zones.

Conversely, the electromechanical system of Figures 5 to 7 (two pistons) may include only three pivot hinges per transmission device 14a, 14b, one at the movable electrode 151, 152 and one at each end of the transmission shaft 144a, 144b.

The electromechanical system 2 has been described taking as an example a microphone with capacitive detection comprising one or several pistons 13, 13a-13b each equipped with a membrane 131 subjected on the one hand to atmospheric pressure and on the other hand to a reference pressure. However, the electromechanical system can form other types of capacitive detection transducer, in particular a loudspeaker (sound emitter) or an ultrasound emitter (which are electroacoustic transducers), or even a differential pressure sensor.

In the case of a differential pressure sensor, the first face of the membrane 131 (of each piston) is subjected to a first pressure (not necessarily atmospheric pressure) and the second face of the membrane 131 is subjected to a second pressure, different from the first pressure. The displacement of the membrane 131, under the effect of the pressure difference, is measured by the capacitive detection means 15'. The membrane 131 of the piston is integral with the frame 10 so as to be sealed and the rigidifying structure 132 of the piston is absent or reduced so as not to anchor it to the frame.

In the case of a loudspeaker or an ultrasound transmitter, capacitive actuation means replace the capacitive detection means 15'. These capacitive actuation means also comprise two movable electrodes and at least one counter-electrode per movable electrode. The movable electrodes are moved by an electrostatic force and this movement is transmitted by the transmission devices 14a, 14b to the piston 13 or pistons 13a-13b. The movement of the membrane 131 of the piston or pistons 13, 13a-13b enables sound (or ultrasound) to be emitted.

The second zone 12 may comprise two chambers under a controlled atmosphere, one containing the first movable electrode 151, the other containing the second movable electrode 152.

The first and second sealed zones 11-12 are not necessarily subjected to different pressures. The first zone 11 may also be an aggressive environment and the movable electrodes of the capacitive means (of detection or actuation) are placed in the second zone 12 to protect them from this aggressive environment (in addition to reducing viscous friction, and therefore acoustic noise).

The electromechanical system 2 may even be devoid of sealing means between the first and second zones 11-12 (which amounts to considering only one zone). More particularly, the pivot hinges 16 may not have any sealed insulating element 161. Indeed, the torsion blades 162 may suffice for the rotation of the transmission device 14a, 14b and as elastic "anti-pull-in" means.

## Claims

1. An electromechanical system (2) comprising:
- a frame (10);
- a first element (13a) movable relative to the frame (10); and
- capacitive measurement or actuation means (15') comprising:
∘ a first electrode (151) movable relative to the frame (10); and
∘ at least one electrode (153, 154) fixed relative to the frame (10) and separated from the first movable electrode (151) by a first dielectric medium;
- a first movement transmission device (14a) connecting the first movable element (13a) to the first movable electrode (151), the first transmission device (14a) being rotatably movable relative to the frame (10) by means of a plurality of first pivot hinges (16a);
**characterised in that** it further comprises a second element (13b) movable relative to the frame (10) and **in that** the second movable element (13b) is connected to the capacitive measurement or actuation means (15').

2. The system (2) according to claim 1, wherein the first movement transmission device (14a) further connects the second movable element (13b) to the first movable electrode (151).

3. The system (2) according to claim 2, wherein the capacitive measurement or actuation means (15') further comprises:
- a second electrode (152) movable relative to the frame (10); and
- at least one additional electrode fixed relative to the frame (10) and separated from the second movable electrode (152) by a second dielectric medium;
the system further comprising a second movement transmission device (14b) connecting the first movable element (13a) and the second movable element (13b) to the second movable electrode (152), the second transmission device (14b) being rotatably movable relative to the frame (10) by means of a plurality of second pivot hinges (16b).

4. The system (2) according to one of claims 2 and 3, wherein the first transmission device (14a) comprises:
- a first transmission shaft (144a) having a first longitudinal axis of rotation (Xa);
- at least one first transmission arm (145a) comprising a first end coupled to the first movable element (13a) and a second end integral with the first transmission shaft (144a); and
- at least one second transmission arm (145c) comprising a first end coupled to the second movable element (13b) and a second end integral with the first transmission shaft (144a).

5. The system (2) according to any one of claims 1 to 4, wherein each of the first and second movable elements (13a, 13b) comprises a membrane (131) and a rigidifying structure (132) for rigidifying the membrane.

6. The system (2) according to claim 5, wherein the first transmission device (14a) is located on a first side of the membrane (131) of the first movable element (13a) and wherein the rigidifying structure (132) of the first movable element comprises a first beam (1321) located on the first side of the membrane (131), the first beam (1321) extending in the length direction of the first movable element (13a), preferably along a median line (M) of the first movable element (13a).

7. The system (2) according to claim 6, wherein the first beam (1321) has a length greater than or equal to 50% of the length of the first movable element (13a).

8. The system (2) according to one of claims 6 and 7, wherein the rigidifying structure (132) of the first movable element (13a) further comprises a second beam (1322) located on a second opposite side of the membrane (131) and superimposed on the first beam (1321).

9. The system (2) according to any one of claims 6 to 8, wherein the rigidifying structure (132) of the first movable element (13a) further comprises ridges (1323) located on a second opposite side of the membrane (131) and extending perpendicularly to the first beam (1321).

10. The system (2) according to any one of claims 1 to 9, wherein the first movable element (13a) and the second movable element (13b) are identical.

11. The system (2) according to any one of claims 1 to 10, wherein the capacitive measurement or actuation means (15') are located between the first movable element (13a) and the second movable element (13b).

12. The system (2) according to claim 11, wherein:
- at least one of the first pivot hinges (16a) is located at the first movable electrode (151),
- another of the first pivot hinges (16a) is located at a first end of the first transmission device (14a);
- another of the first pivot hinges (16a) is located at a second, opposite end of the first transmission device (14a).

13. A system (2) according to any one of claims 1 to 12, wherein the first movable element (13a) and the second movable element (13b) are in contact with a first zone (11) and the first movable electrode (151) is located in a second zone (12) sealingly isolated from the first zone (11).

## Patentansprüche

1. Elektromechanisches System (2), umfassend:
- einen Rahmen (10);
- ein erstes Element (13a), das relativ zum Rahmen (10) beweglich ist; und
- kapazitive Mess- oder Betätigungsmittel (15'), umfassend:
∘ eine erste Elektrode (151), die relativ zum Rahmen (10) beweglich ist; und
∘ mindestens eine gegenüber dem Rahmen (10) feststehende Elektrode (153, 154), die von der ersten beweglichen Elektrode (151) durch ein erstes dielektrisches Medium getrennt ist;
- eine erste Bewegungsübertragungsvorrichtung (14a), die das erste bewegliche Element (13a) mit der ersten beweglichen Elektrode (151) verbindet, wobei die erste Übertragungsvorrichtung (14a) mittels einer Vielzahl von ersten Schwenkgelenken (16a) relativ zum Rahmen (10) drehbar ist;
**dadurch gekennzeichnet, dass** es ferner ein zweites, relativ zum Rahmen (10) bewegliches Element (13b) umfasst und dass das zweite bewegliche Element (13b) mit den kapazitiven Mess- oder Betätigungsmitteln (15') verbunden ist.

2. System (2) nach Anspruch 1, bei dem die erste Bewegungsübertragungsvorrichtung (14a) ferner das zweite bewegliche Element (13b) mit der ersten beweglichen Elektrode (151) verbindet.

3. System (2) nach Anspruch 2, bei dem die kapazitiven Mess- oder Betätigungsmittel (15') ferner umfassen:
- eine zweite, relativ zum Rahmen (10) bewegliche Elektrode (152); und
- mindestens eine weitere, relativ zum Rahmen (10) feststehende Elektrode, die von der zweiten beweglichen Elektrode (152) durch ein zweites dielektrisches Medium getrennt ist;
wobei das System ferner eine zweite Bewegungsübertragungsvorrichtung (14b) umfasst, die das erste bewegliche Element (13a) und das zweite bewegliche Element (13b) mit der zweiten beweglichen Elektrode (152) verbindet, wobei die zweite Übertragungsvorrichtung (14b) mittels einer Vielzahl von zweiten Schwenkgelenken (16b) drehbar ist.

4. System (2) nach einem der Ansprüche 2 und 3, bei dem die erste Übertragungsvorrichtung (14a) umfasst:
- eine erste Übertragungswelle (144a) mit einer ersten Längsdrehachse (Xa);
- mindestens einen ersten Übertragungsarm (145a) mit einem ersten Ende, das mit dem ersten beweglichen Element (13a) gekoppelt ist, und einem zweiten Ende, das fest mit der ersten Übertragungswelle (144a) verbunden ist; und
- mindestens einen zweiten Übertragungsarm (145c), der ein erstes, mit dem zweiten beweglichen Element (13b) gekoppeltes Ende und ein zweites, fest mit der ersten Übertragungswelle (144a) verbundenes Ende aufweist.

5. System (2) nach einem der Ansprüche 1 bis 4, bei dem sowohl das erste als auch das zweite bewegliche Element (13a, 13b) eine Membran (131) und eine Versteifungsstruktur (132) zum Versteifen der Membran umfasst.

6. System (2) nach Anspruch 5, bei dem sich die erste Übertragungsvorrichtung (14a) auf einer ersten Seite der Membran (131) des ersten beweglichen Elements (13a) befindet und bei dem die Versteifungsstruktur (132) des ersten beweglichen Elements einen ersten Träger (1321) umfasst, der sich auf der ersten Seite der Membran (131) befindet, wobei sich der erste Träger (1321) in Längsrichtung des ersten beweglichen Elements (13a) erstreckt, vorzugsweise entlang einer Mittellinie (M) des ersten beweglichen Elements (13a).

7. System (2) nach Anspruch 6, bei dem der erste Träger (1321) eine Länge aufweist, die größer oder gleich 50 % der Länge des ersten beweglichen Elements (13a) ist.

8. System (2) nach einem der Ansprüche 6 und 7, bei dem die Versteifungsstruktur (132) des ersten beweglichen Elements (13a) ferner einen zweiten Träger (1322) umfasst, der sich auf einer zweiten, gegenüberliegenden Seite der Membran (131) befindet und über dem ersten Träger (1321) angeordnet ist.

9. System (2) nach einem der Ansprüche 6 bis 8, bei dem die Versteifungsstruktur (132) des ersten beweglichen Elements (13a) ferner Rippen (1323) umfasst, die sich auf einer zweiten, gegenüberliegenden Seite der Membran (131) befinden und sich senkrecht zum ersten Träger (1321) erstrecken.

10. System (2) nach einem der Ansprüche 1 bis 9, bei dem das erste bewegliche Element (13a) und das zweite bewegliche Element (13b) identisch sind.

11. System (2) nach einem der Ansprüche 1 bis 10, bei dem sich die kapazitiven Mess- oder Betätigungsmittel (15') zwischen dem ersten beweglichen Element (13a) und dem zweiten beweglichen Element (13b) befinden.

12. System (2) nach Anspruch 11, bei dem:
- mindestens eines der ersten Schwenkgelenke (16a) sich auf Höhe der ersten beweglichen Elektrode (151) befindet,
- ein weiteres der ersten Schwenkgelenke (16a) an einem ersten Ende der ersten Übertragungsvorrichtung (14a) angeordnet ist;
- ein weiteres der ersten Schwenkgelenke (16a) sich an einem zweiten, gegenüberliegenden Ende der ersten Übertragungsvorrichtung (14a) befindet.

13. System (2) nach einem der Ansprüche 1 bis 12, bei dem das erste bewegliche Element (13a) und das zweite bewegliche Element (13b) mit einem ersten Bereich (11) in Kontakt stehen und die erste bewegliche Elektrode (151) in einem zweiten Bereich (12) angeordnet ist, der gegenüber dem ersten Bereich (11) abdichtend isoliert ist.

## Revendications

1. Système électromécanique (2) comprenant :
- un bâti (10) ;
- un premier élément mobile (13a) par rapport au bâti (10) ; et
- des moyens capacitifs de mesure ou d'actionnement (15') comprenant :
∘ une première électrode mobile (151) par rapport au bâti (10) ; et
∘ au moins une électrode (153, 154) fixe par rapport au bâti (10) et séparée de la première électrode mobile (151) par un premier milieu diélectrique ;
- un premier dispositif de transmission de mouvement (14a) reliant le premier élément mobile (13a) à la première électrode mobile (151), le premier dispositif de transmission (14a) étant mobile en rotation par rapport au bâti (10) au moyen d'une pluralité de premières articulations pivot (16a) ;
**caractérisé en ce qu'**il comprend en outre un deuxième élément (13b) mobile par rapport au bâti (10) et **en ce que** le deuxième élément mobile (13b) est relié aux moyens capacitifs de mesure ou d'actionnement (15').

2. Système (2) selon la revendication 1, dans lequel le premier dispositif de transmission de mouvement (14a) relie en outre le deuxième élément mobile (13b) à la première électrode mobile (151).

3. Système (2) selon la revendication 2, dans lequel les moyens capacitifs de mesure ou d'actionnement (15') comprennent en outre :
- une deuxième électrode (152) mobile par rapport au bâti (10) ; et
- au moins une électrode additionnelle fixe par rapport au bâti (10) et séparée de la deuxième électrode mobile (152) par un deuxième milieu diélectrique ;
le système comprenant en outre un deuxième dispositif de transmission de mouvement (14b) reliant le premier élément mobile (13a) et le deuxième élément mobile (13b) à la deuxième électrode mobile (152), le deuxième dispositif de transmission (14b) étant mobile en rotation par rapport au bâti (10) au moyen d'une pluralité de deuxièmes articulations pivot (16b).

4. Système (2) selon l'une des revendications 2 et 3, dans lequel le premier dispositif de transmission (14a) comprend :
- un premier arbre de transmission (144a) présentant un premier axe longitudinal de rotation (Xa) ;
- au moins un premier bras de transmission (145a) comprenant une première extrémité couplée au premier élément mobile (13a) et une deuxième extrémité solidaire du premier arbre de transmission (144a) ; et
- au moins un deuxième bras de transmission (145c) comprenant une première extrémité couplée au deuxième élément mobile (13b) et une deuxième extrémité solidaire du premier arbre de transmission (144a).

5. Système (2) selon l'une quelconque des revendications 1 à 4, dans lequel chacun des premier et deuxième éléments mobiles (13a, 13b) comprend une membrane (131) et une structure de rigidification (132) de la membrane.

6. Système (2) selon la revendication 5, dans lequel le premier dispositif de transmission (14a) est situé d'un premier côté de la membrane (131) du premier élément mobile (13a) et dans lequel la structure de rigidification (132) du premier élément mobile comprend une première poutre (1321) située du premier côté de la membrane (131), la première poutre (1321) s'étendant dans le sens de la longueur du premier élément mobile (13a), de préférence suivant une ligne médiane (M) du premier élément mobile (13a).

7. Système (2) selon la revendication 6, dans lequel la première poutre (1321) présente une longueur supérieure ou égale à 50 % de la longueur du premier élément mobile (13a).

8. Système (2) selon l'une des revendications 6 et 7, dans lequel la structure de rigidification (132) du premier élément mobile (13a) comprend en outre une deuxième poutre (1322) située d'un deuxième côté opposé de la membrane (131) et superposée à la première poutre (1321).

9. Système (2) selon l'une quelconque des revendications 6 à 8, dans lequel la structure de rigidification (132) du premier élément mobile (13a) comprend en outre des arêtes (1323) situés d'un deuxième côté opposé de la membrane (131) et s'étendant perpendiculairement à la première poutre (1321).

10. Système (2) selon l'une quelconque des revendications 1 à 9, dans lequel le premier élément mobile (13a) et le deuxième élément mobile (13b) sont identiques.

11. Système (2) selon l'une quelconque des revendications 1 à 10, dans lequel les moyens capacitifs de mesure ou d'actionnement (15') sont situés entre le premier élément mobile (13a) et le deuxième élément mobile (13b).

12. Système (2) selon la revendication 11, dans lequel :
- au moins une des premières articulations pivot (16a) est située au niveau de la première électrode mobile (151),
- une autre des premières articulations pivot (16a) est située à une première extrémité du premier dispositif de transmission (14a) ;
- une autre des premières articulations pivot (16a) est située à une deuxième extrémité opposée du premier dispositif de transmission (14a).

13. Système (2) selon l'une quelconque des revendications 1 à 12, dans lequel le premier élément mobile (13a) et le deuxième élément mobile (13b) sont en contact avec une première zone (11) et la première électrode mobile (151) est située dans une deuxième zone (12) isolée de manière étanche de la première zone (11).
